# EUROPEAN PATENT APPLICATION

(11) **EP 4 836 270 A1**
(43) Date of publication of application: **04.11.2026**
(21) Application number: 24921825.6
(22) Date of filing: 31.12.2024
(51) Int. Cl.: H02M 3/156, H02M 1/36, H02M 1/32, H02M 7/42, H02J 3/32, H02J 7/35, H02J 3/38, H02J 9/06, G01R 19/165

(54) **POWER CONVERSION APPARATUS AND DETECTION METHOD**

(30) Priority: 31.01.2024 CN 202410153068
(71) Applicant: Huawei Digital Power Technologies Co., Ltd., Shenzhen, Guangdong 518043 (CN)
(72) Inventor: QIU, Xiaodong, Shenzhen, Guangdong 518043 (CN); FU, Mingxiao, Shenzhen, Guangdong 518043 (CN); WU, Rong, Shenzhen, Guangdong 518043 (CN); WANG, Xiaohui, Shenzhen, Guangdong 518043 (CN); TANG, Shun, Shenzhen, Guangdong 518043 (CN)
(74) Representative: Huawei European IPR
(86) International application number: PCT/CN2024/144123
(87) International publication number: WO 2025/161803

(57) **Abstract**

Embodiments provide a power conversion apparatus and a detection method, applied to the field of power supply processing technologies. The power conversion apparatus includes a control circuit and a direct current/direct current conversion circuit. The direct current/direct current conversion circuit includes an inductor and a switching transistor. The switching transistor is configured to connect in parallel to a direct current power supply. The inductor is connected in series to a loop formed by the direct current power supply and the switching transistor. The control circuit is configured to: in a startup process of the power conversion apparatus, control the switching transistor to be continuously turned on within target duration or control the switching transistor to be turned on and off within a target quantity of switching cycles; and after the target duration, when a current value of the inductor is greater than a preset current threshold, determine that adjacent winding coils of the inductor are short-circuited to each other, and perform an inductor abnormality handling operation. In embodiments, duration of sending a PWM driver gating signal is controlled in a startup phase of the power conversion apparatus, to implement abnormal startup detection of the inductor on a direct current side of the power conversion apparatus while ensuring operating safety.

## Description

This application claims priority to Chinese Patent Application No. 202410153068.7, filed with the China National Intellectual Property Administration on January 31, 2024 and entitled "POWER CONVERSION APPARATUS AND DETECTION METHOD", which is incorporated herein by reference in its entirety.

### TECHNICAL FIELD

This application relates to the field of power supply processing technologies, and in particular, to a power conversion apparatus and a detection method.

### BACKGROUND

In the power supply processing field (for example, the photovoltaic power supply field), a power conversion apparatus may be used to perform power conversion processing on a power supply signal. The power supply signal has two forms of a direct current and an alternating current during transmission and processing. When power conversion is performed on the power supply signal in different application scenarios, conversion processing (namely, direct current/alternating current conversion) may be performed between the direct current and the alternating current, and/or conversion processing (namely, direct current/direct current conversion) may be performed between the direct currents.

An inductor is usually disposed in an existing power conversion circuit. Operating safety of the inductor is related to safety and reliability of a power supply system. Generally, a related component configured to detect the operating safety of the inductor is usually disposed on an alternating current side (for example, a direct current/alternating current conversion circuit) of the power conversion circuit. However, there is always no related component, for detecting the safety of the inductor, on a direct current side (for example, a direct current/direct current conversion circuit) of the power conversion circuit. Especially, there is no detection on the safety of the inductor in the direct current/direct current conversion circuit in the power conversion apparatus in a startup phase.

### SUMMARY

Embodiments of this application provide a power conversion apparatus and a detection method, to implement accurate detection on safety of an inductor on a current side.

To achieve the foregoing objectives, the following technical solutions are used in embodiments of this application.

According to a first aspect, a power conversion apparatus is provided. The power conversion apparatus includes a control circuit and a direct current/direct current conversion circuit. The direct current/direct current conversion circuit includes an inductor and a switching transistor. The switching transistor is configured to connect in parallel to a direct current power supply. The inductor is connected in series to a loop formed by the direct current power supply and the switching transistor. The control circuit is configured to: in a startup process of the power conversion apparatus, control the switching transistor to be continuously turned on within target duration or control the switching transistor to be turned on and off within a target quantity of switching cycles; and perform an inductor abnormality handling operation after the target duration or the target quantity of switching cycles when a current flowing through the inductor is greater than a preset current threshold.

For example, startup of the power conversion apparatus means that the power conversion apparatus is connected to an operating power supply of a device to implement power-on. After the power conversion apparatus is powered on, the control circuit in the power conversion apparatus is also powered on. After the control circuit is powered on, there is a self-check process, and each piece of operating state information of the power conversion apparatus may be detected, to ensure operating stability and safety of the power conversion apparatus. For example, a status of the inductor in the direct current/direct current conversion circuit in the power conversion apparatus may be detected. In this way, subsequent soft starting of the direct current/direct current conversion circuit and operating of a direct current/alternating current conversion circuit can be performed. The startup process of the power conversion apparatus in this application is a process in which the power conversion apparatus performs self-check after being powered on. It may be understood that in some possible scenarios, inductor detection may also be performed in an operating process of the direct current/alternating current conversion circuit.

For example, based on the target duration of continuous turn-on, the switching transistor may remain in a continuous turn-on state within the target duration. For example, when the switching transistor is controlled to be turned on based on a switching cycle, a duty cycle of the switching transistor in the switching cycle is determined, in other words, there is a turn-on state with a determined proportion of duration and a turn-off state with a determined proportion of duration. When the switching transistor is controlled to be turned on based on a plurality of switching cycles, the switching transistor is in a discontinuous turn-on state in the plurality of cycles. In the manner of controlling the switching transistor to be turned on based on the switching cycle, a voltage conversion ratio and the like of the direct current/direct current conversion circuit may be controlled by adjusting a duty cycle (that is, a ratio of a turn-on state to a turn-off state) in each switching cycle. In actual application, a turn-on control manner may be adaptively designed based on an application scenario requirement.

For the inductor, there is an inductor characteristic formula, and the inductor characteristic formula is used to describe a relationship between an inductance of the inductor and the current flowing through the inductor. In the direct current/direct current conversion circuit in the power conversion apparatus, the direct current/direct current conversion circuit is started for operating when a direct current is input. The inductor and the switching transistor are designed in the direct current/direct current conversion circuit. Direct current-direct current power conversion processing is implemented based on the switching transistor and the inductor. However, in a phase in which the direct current/direct current conversion circuit is started for operating, if an insulation layer on an outer surface of a winding coil of the inductor is broken, a short circuit occurs between adjacent windings, and consequently, an inter-turn short circuit occurs in the inductor. Therefore, safety detection needs to be performed on the inductor in a startup phase of the direct current/direct current conversion circuit in the power conversion apparatus. In an existing inductor detection solution, there is a detection manner in which an actual inductance of the inductor is directly calculated according to the inductor characteristic formula to determine whether the inductor is abnormal. However, this manner is not applicable to inductor abnormality detection on the direct current/direct current conversion circuit. This is because when the inductor in the direct current/direct current conversion circuit in the power conversion apparatus is detected, the direct current/direct current conversion circuit needs to be in a normal operating state. When a direct current provided by a direct current power supply is input to the direct current/direct current conversion circuit, a high inductor current flows through the inductor in the direct current/direct current conversion circuit. In this case, although the status of the inductor may be detected according to the inductor characteristic formula, the current flowing through the inductor is extremely high. If the inductor is an abnormal inductor, an inductor current flowing through the inductor is greater than that flowing through a normal inductor. In this detection manner, the abnormal inductor needs to be allowed to operate. When the abnormal inductor operates, the inductor current flowing through the abnormal inductor is sufficient to damage the power conversion apparatus. As a result, this detection manner in which the actual inductance of the inductor is directly detected according to the inductor characteristic formula cannot avoid a safety problem caused by an abnormality of the inductor, and this detection manner cannot be applied to a startup phase of the power conversion apparatus. Currently, there is no solution for performing safety detection on the inductor in the direct current/direct current conversion circuit in the startup phase. In this embodiment of this application, in the startup process of the power conversion apparatus, only the control circuit needs to control the switching transistor to be turned on within the target duration. Under determined turn-on duration and a determined input voltage, inductors with different inductances have different currents. Each inductance during normal operating is a rated inductance known before delivery of this inductor product. When the winding of the inductor is short-circuited, an inductance of the short-circuited inductor attenuates. Therefore, in actual application, the target duration or the target quantity of switching cycles are properly designed, provided that the target duration or the target quantity of switching cycles meet a condition that a current of the short-circuited inductor does not damage the power conversion apparatus. In this implementation, under same turn-on duration and a same input voltage, the inductance of the inductor is inversely proportional to the current flowing through the inductor. Therefore, the current flowing through the short-circuited inductor is greater than the current flowing through the normal inductor. In actual application, the current that flows through the inductor and that is obtained based on the target duration or the target quantity of switching cycles is determined. If the current flowing through the detected inductor is greater than a specific preset current threshold, it indicates that the winding coils of the inductor are short-circuited to each other. In this case, the related inductor abnormality handling operation may be performed.

In a possible implementation, the control circuit includes a sampling circuit, an overcurrent protection circuit, and a control chip. The sampling circuit is separately connected to an output end of the inductor and the overcurrent protection circuit. The overcurrent protection circuit is further connected to the control chip. The sampling circuit is configured to: obtain the current flowing through the inductor, and transmit the current to the overcurrent protection circuit. The overcurrent protection circuit is configured to output an abnormality indication signal to the control chip when the current flowing through the inductor is greater than the preset current threshold. The control chip is configured to perform the inductor abnormality handling operation based on the abnormality indication signal. In this embodiment of this application, the overcurrent protection circuit is disposed in the control circuit in the power conversion apparatus. In this case, the overcurrent protection circuit determines a value relationship between the current flowing through the inductor and the preset current threshold based on the current that flows through the inductor and that is obtained through sampling, to determine an abnormality of the inductor. When the adjacent windings of the inductor are in a short-circuit state, the overcurrent protection circuit may send a corresponding abnormality indication signal to the control chip. The control chip performs a corresponding inductor abnormality handling operation based on the abnormality indication signal.

In a possible implementation, the control circuit includes a sampling circuit and a control chip. The sampling circuit is separately connected to an output end of the inductor and the control chip. The sampling circuit is configured to: obtain the current flowing through the inductor, and transmit the current to the overcurrent protection circuit. The control chip is configured to perform the inductor abnormality handling operation when the current flowing through the inductor is greater than the preset current threshold. In this embodiment of this application, the sampling circuit may obtain the current at the output end of the inductor through sampling. The control chip determines, based on the value relationship between the current flowing through the inductor and the preset current threshold, whether the inductor is abnormal. When determining that the current flowing through the inductor is greater than the preset current threshold, the control chip may perform the corresponding inductor abnormality handling operation.

In a possible implementation, the preset current threshold is greater than a rated peak current. The rated peak current is determined based on an input voltage of the inductor, a rated inductance of the inductor, and the target duration, or the rated peak current is determined based on an input voltage of the inductor, a rated inductance of the inductor, and the target quantity of switching cycles. The rated inductance is an inductance of the inductor during normal operating.

In some examples, the preset current threshold is further less than an abnormal peak current. The abnormal peak current is determined based on the input voltage of the inductor, an attenuated inductance of the inductor, and the target duration, or the abnormal peak current is determined based on the input voltage of the inductor, an attenuated inductance of the inductor, and the target quantity of switching cycles. The attenuated inductance is an inductance of the inductor in a state in which adjacent winding coils are short-circuited to each other.

In this embodiment of this application, the rated inductance is the inductance of the inductor during normal operating. The attenuated inductance is the inductance of the inductor in the state in which the adjacent winding coils are short-circuited to each other. In this embodiment of this application, specific values of the rated peak current and the abnormal peak current are determined based on inductances corresponding to a normal inductor and the abnormal inductor. Each inductor has a rated inductance, namely, a normal inductance L1 during normal operating. When the input voltage Upv of the inductor in the direct current/direct current conversion circuit is determined, the normally operating inductor has a corresponding rated peak current i1. According to an inductor characteristic formula L*di/dt=U (in the formula, i is a current, t is duration, di is a current variation, dt is a time variation, U is an input voltage, and L is an actual inductance), it can be learned that when the inductor normally operates, the inductance of the inductor is the normal inductance L1, and charging current duration is fixed at t1. In this case, a formula for calculating the corresponding rated peak current i1 is: i1=Upv*t1/L1. When the inductor is short-circuited, the inductance of the inductor attenuates. In this case, the inductance of the inductor is the attenuated inductance L2. The charging current duration is fixed at t1. In this case, a formula for calculating the corresponding abnormal peak current i2 is: i2=Upv*t1/L2. In conclusion, it can be learned that when the inductor is in the normal operating state and the short-circuit state, actual inductances of the inductor are different. In other words, the inductance of the inductor is inversely proportional to the current flowing through the inductor. When the current duration is fixed, output currents corresponding to the two states are different. The preset current threshold may be set between the rated peak current and the abnormal peak current, and the normal inductor and the abnormal inductor can be distinguished based on the preset current threshold.

In a possible implementation, a first absolute value is equal to a second absolute value, the first absolute value is an absolute value of a difference between the preset current threshold and the rated peak current, and the second absolute value is an absolute value of a difference between the preset current threshold and the abnormal peak current. In this embodiment of this application, when the inductor is short-circuited, the inductance of the inductor attenuates. In this case, the inductance of the inductor is the attenuated inductance L2, and the charging current duration is fixed at t1. In this case, a formula for calculating the corresponding abnormal peak current i2 is: i2=Upv*t1/L2. In this case, based on the target duration or the target quantity of switching cycles, the value of the preset current threshold a may be between the rated peak current i1 and the abnormal peak current i2. Because i1<a<i2, an equation between the first absolute value and the second absolute value may also be expressed as: (i2-a)=(a-i1). In this embodiment of this application, the difference between the preset current threshold a and the rated peak current i1 is equal to the difference between the preset current threshold a and the abnormal peak current i2. In this case, a detection result may have high reliability.

In a possible implementation, the control circuit is further configured to: when the current flowing through the inductor is less than or equal to the preset current threshold, keep the power conversion apparatus started. In this embodiment of this application, in the startup phase of the power conversion apparatus, when it is detected that the current flowing through the inductor is less than or equal to the preset current threshold, it indicates that the inductor on a direct current side of the power conversion apparatus is in a normal state. In this case, when the power conversion apparatus has no other fault, a startup action of the power conversion apparatus can be maintained, so that the power conversion apparatus is normally put into use.

In a possible implementation, the control circuit is further configured to: when the direct current/direct current conversion circuit of the power conversion apparatus is in an operating state, obtain an operating current, in the operating state, of the current flowing through the inductor; determine the actual inductance of the inductor based on the operating current of the current flowing through the inductor; and perform the inductor abnormality handling operation when the actual inductance of the inductor is less than a preset inductance threshold. In this embodiment of this application, after the power conversion apparatus is started, when the direct current/direct current conversion circuit is in the operating state, the actual inductance of the inductor may be calculated based on an actually detected operating current, and whether the inductor on the direct current side of the power conversion apparatus normally operates is determined based on the actual inductance of the inductor. The inductor on the direct current side of the power conversion apparatus can be systematically and comprehensively detected based on the inductor detection in the startup process of the power conversion apparatus and the inductor detection performed when the direct current/direct current conversion circuit is in an operating phase.

In an example, determining the actual inductance of the inductor based on the operating current of the current flowing through the inductor includes: when the operating current flowing through the inductor is a continuous inductor current, determining the actual inductance of the inductor through calculation according to a continuous inductor current algorithm and based on the obtained operating current; or when the current flowing through the inductor is a discontinuous inductor current, determining the actual inductance of the inductor through calculation according to a discontinuous inductor current algorithm and based on the obtained operating current. In this embodiment of this application, a corresponding calculation method may be matched based on different inductor current signal conditions, to implement comprehensive abnormality calculation of the inductor in different operating conditions in the operating state.

In a possible implementation, the inductor abnormality handling operation includes controlling the power conversion apparatus to be shut down, outputting inductor abnormality alarm information, reducing input power of the inductor, or the like. In this embodiment of this application, different inductor abnormality handling operations may be adaptively designed based on different scenarios, for example, controlling the power conversion apparatus to be shut down, outputting the inductor abnormality alarm information, or reducing the input power of the inductor.

In some possible implementations, the direct current/direct current conversion circuit further includes an input capacitor, an output capacitor, and a diode. The diode is connected in series to the output end of the inductor, and the switching transistor is connected between the inductor and the diode. The input capacitor and the output capacitor are separately connected in parallel to the switching transistor, the input capacitor is connected to an input end side of the inductor, and the output capacitor is connected to an output end side of the diode. In this embodiment of this application, the input capacitor and the output capacitor may respectively implement filtering processing at an input end and an output end of the direct current/direct current conversion circuit. The diode can ensure undirectional conductivity of current transmission at the output end of the inductor. After the input capacitor is disposed, a voltage at the input capacitor is the input voltage corresponding to the inductor in the direct current/direct current conversion circuit.

In some possible implementations, the power conversion apparatus further includes a direct current/alternating current conversion circuit, and an input end of the direct current/alternating current conversion circuit is connected to an output end of the direct current/direct current conversion circuit. In this embodiment of this application, the direct current/alternating current conversion circuit may be further disposed in the power conversion apparatus. The direct current/alternating current conversion circuit may obtain the direct current from the direct current/direct current conversion circuit, and convert the direct current to obtain an alternating current. The alternating current may be transmitted to an alternating current powered apparatus (for example, a power grid and/or a load device).

According to a second aspect, an embodiment of this application further provides a detection method, applied to a power conversion apparatus. The power conversion apparatus includes a direct current/direct current conversion circuit. The direct current/direct current conversion circuit includes an inductor and a switching transistor. The switching transistor is configured to connect in parallel to a direct current power supply. The inductor is connected in series to a loop formed by the direct current power supply and the switching transistor. The method includes: in a startup process of the power conversion apparatus, controlling the switching transistor to be continuously turned on within target duration or controlling the switching transistor to be turned on and off within a target quantity of switching cycles; and performing an inductor abnormality handling operation after the target duration or the target quantity of switching cycles when a current flowing through the inductor is greater than a preset current threshold.

In a possible implementation, performing the inductor abnormality handling operation when the current value flowing through the inductor is greater than the preset current threshold includes: obtaining an abnormality indication signal when the current flowing through the inductor is greater than the preset current threshold; and performing the inductor abnormality handling operation based on the abnormality indication signal.

In a possible implementation, the preset current threshold is greater than a rated peak current. The rated peak current is determined based on an input voltage of the inductor, a rated inductance of the inductor, and the target duration, or the rated peak current is determined based on an input voltage of the inductor, a rated inductance of the inductor, and the target quantity of switching cycles. The rated inductance is an inductance of the inductor during normal operating.

In some examples, the preset current threshold is further less than an abnormal peak current. The abnormal peak current is determined based on the input voltage of the inductor, an attenuated inductance of the inductor, and the target duration, or the abnormal peak current is determined based on the input voltage of the inductor, an attenuated inductance of the inductor, and the target quantity of switching cycles. The attenuated inductance is an inductance of the inductor in a state in which adjacent winding coils are short-circuited to each other.

In a possible implementation, a first absolute value is equal to a second absolute value, the first absolute value is an absolute value of a difference between the preset current threshold and the rated peak current, and the second absolute value is an absolute value of a difference between the preset current threshold and the abnormal peak current.

In a possible implementation, the method further includes: when the current flowing through the inductor is less than or equal to the preset current threshold, keeping the power conversion apparatus started.

In a possible implementation, the method further includes: determining an actual inductance of the inductor based on an operating current of the current flowing through the inductor when the direct current/direct current conversion circuit in the power conversion apparatus is in an operating state; and performing the inductor abnormality handling operation when the actual inductance of the inductor is less than a preset inductance threshold.

In a possible implementation, determining the actual inductance of the inductor based on the operating current of the current flowing through the inductor includes: when the current flowing through the inductor is a continuous inductor current, determining the actual inductance of the inductor through calculation according to a continuous inductor current algorithm and based on the operating current at an output end of the inductor; or when the current flowing through the inductor is a discontinuous inductor current, determining the actual inductance of the inductor through calculation according to a discontinuous inductor current algorithm and based on the operating current at an output end of the inductor.

In a possible implementation, the inductor abnormality handling operation includes controlling the power conversion apparatus to be shut down, outputting inductor abnormality alarm information, reducing input power of the inductor, or the like.

For technical principles and beneficial effect of the second aspect, refer to related descriptions of the first aspect. Details are not described herein again.

### BRIEF DESCRIPTION OF DRAWINGS

FIG. 1 is a diagram of a structure of a power supply system according to an embodiment of this application;
FIG. 2 is a diagram of a structure of a first power conversion apparatus in a conventional technology;
FIG. 3 is a diagram of a structure of another first power conversion apparatus in a conventional technology;
FIG. 4 is a diagram of a structure of a second power conversion apparatus according to an embodiment of this application;
FIG. 5 is a diagram 1 in which inductor currents of a normal inductor and a short-circuited inductor change with time according to an embodiment of this application;
FIG. 6 is another diagram 2 in which inductor currents of a normal inductor and a short-circuited inductor change with time according to an embodiment of this application;
FIG. 7 is a diagram 2 of a structure of another second power conversion apparatus according to an embodiment of this application;
FIG. 8 is a diagram 3 of a structure of still another second power conversion apparatus according to an embodiment of this application;
FIG. 9 is a diagram 4 of a structure of yet another second power conversion apparatus according to an embodiment of this application;
FIG. 10 is a schematic flowchart of a detection method according to an embodiment of this application;
FIG. 11 is a still another diagram 3 in which inductor currents of a normal inductor and a short-circuited inductor change with time according to an embodiment of this application;
FIG. 12 is a diagram 1 of inductor charging changes implemented based on a drive signal with a continuous effective pulse width according to an embodiment of this application;
FIG. 13 is a diagram 2 of inductor charging changes implemented based on a drive signal with a discontinuous effective pulse width according to an embodiment of this application;
FIG. 14 is a schematic flowchart of another detection method according to an embodiment of this application; and
FIG. 15 is a diagram of a processing procedure of a second control circuit according to an embodiment of this application.

### DESCRIPTION OF EMBODIMENTS

It should be noted that in embodiments of this application, terms such as "first" and "second" are merely used to distinguish between features of a same type, and cannot be understood as an indication of relative importance, a quantity, a sequence, or the like.

The term such as "example" or "for example" in embodiments of this application is used to represent giving an example, an illustration, or a description. Any embodiment or design scheme described as an "example" or "for example" in this application should not be explained as being more preferred or having more advantages than another embodiment or design scheme. Exactly, use of the word such as "example" or "for example" is intended to present a related concept in a specific manner.

The terms "coupling" and "connection" in embodiments of this application should be understood in a broad sense. For example, the term may be a physical direct connection, or may be an indirect connection implemented through an electronic component, for example, a connection implemented through a resistor, an inductor, a capacitor, or another electronic component.

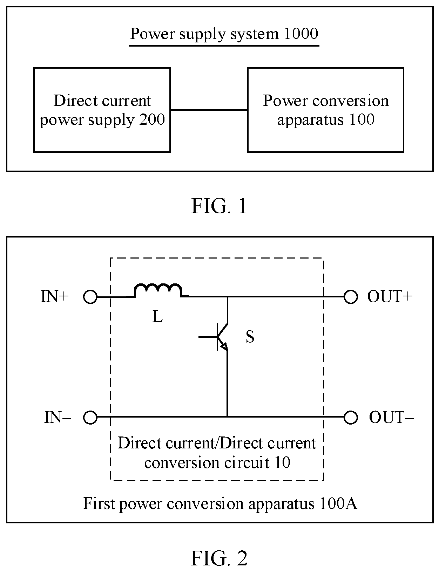

Embodiments of this application provide a power supply system. As shown in FIG. 1, the power supply system 1000 includes a direct current power supply 200 and a power conversion apparatus 100. An input end of the power conversion apparatus 100 is connected to an output end of the direct current power supply 200, to obtain a direct current from the direct current power supply 200. For example, when the power supply system 1000 is a photovoltaic power supply system, the direct current power supply 200 may be a photovoltaic array. For example, when the power supply system 1000 is a power supply system in a scenario of power supplying of an uninterruptible power supply, the direct current power supply 200 may be an energy storage device built in or built outside the power conversion apparatus 100, or the like.

When the power conversion apparatus 100 shown in FIG. 1 is a first power conversion apparatus that does not include an inductor detection function and that is provided in a conventional technology, as shown in FIG. 2, the first power conversion apparatus 100A includes a direct current/direct current (DC/DC) conversion circuit 10. The direct current/direct current conversion circuit 10 includes an inductor L and a switching transistor S. The switching transistor S is connected to an output end of the inductor LL. For example, an input end of the inductor L is connected to a positive input end IN+ of the direct current/direct current conversion circuit 10, the output end of the inductor L is separately connected to a first end of the switching transistor S and a positive output end OUT+ of the direct current/direct current conversion circuit 10, and a second end of the switching transistor S is separately connected to a negative input end IN- and a negative output end OUT- of the direct current/direct current conversion circuit 10. When an input voltage of the inductor L is fixed, a voltage of a current output by the inductor may be controlled by controlling turn-on duration and/or a turn-on frequency of the switching transistor S, to implement direct-current voltage conversion (for example, boost processing).

In the conventional technology shown in FIG. 2, a pin of the inductor L is soldered to a printed circuit board (printed circuit board, PCB) on which the first power conversion apparatus 100A is located. When an outer insulation layer of a winding is broken due to impact of an external force on the winding of the inductor L, a short circuit occurs between adjacent windings of the inductor L, and consequently, an inter-turn short circuit occurs in the inductor L. After the inter-turn short circuit occurs, a current flowing into the winding of the short-circuited inductor L sharply increases to dozens of times a normal current. After heat conduction effect, a temperature at the pin of the inductor L sharply increases, resulting in problems such as carbonization of the PCB and burnout and smoking of the first power conversion apparatus 100A. Generally, there is no related component, for detecting safety of the inductor exists, on a current side.

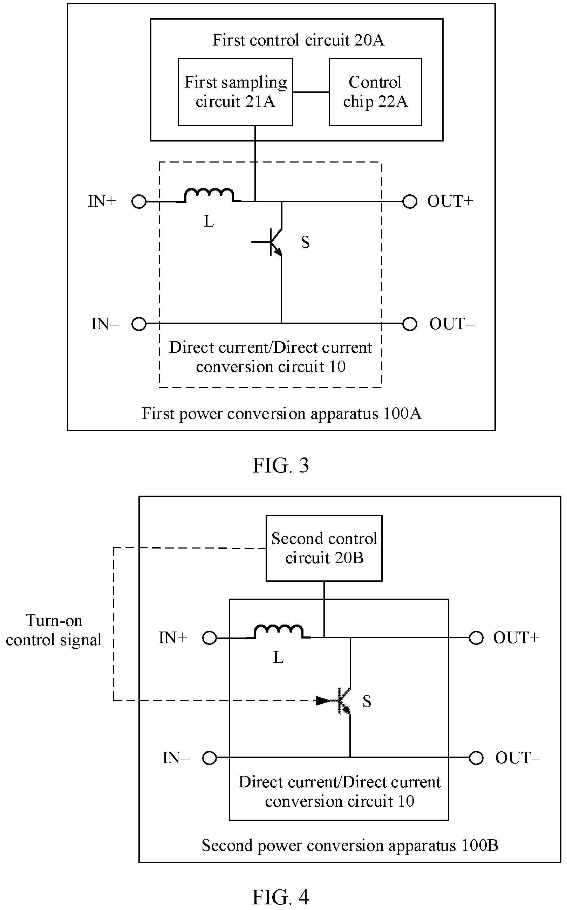

In some possible implementations, as shown in FIG. 3, a first control circuit 20A may be disposed in the first power conversion apparatus 100A in the conventional technology. The first control circuit 20A includes a first sampling circuit 21A and a controller 22A. The first sampling circuit 21A is connected to the output end of the inductor L. The first sampling circuit 21A is configured to: when the first power conversion apparatus 100A is in an operating state, obtain a current output by the inductor L. The controller 22A is configured to: calculate an actual inductance of the inductor L based on the current flowing through the inductor L and according to a calculation algorithm in a continuous inductor current condition, and determine, based on the calculated actual inductance, whether the inductor L abnormally operates. However, in this manner, the inductor L of the direct current/direct current conversion circuit 10 can be detected and calculated only when the power supply system normally operates. In addition, this calculation is detection and calculation in the continuous inductor current condition, and is not applicable to calculation in a discontinuous inductor current condition. In addition, in an existing power factor correction (power factor correction, PFC) circuit, a related component for abnormality detection of an inductor in the PFC circuit is disposed, but the component calculates an inductance only according to a typical inductor characteristic formula, and cannot be directly used in the power supply system 1000. If the inductor L needs to be detected based on an inductor characteristic, the inductor L needs to normally operate. This is because when the inductor in the direct current/direct current conversion circuit 10 in the power conversion apparatus 100 is detected, the direct current/direct current conversion circuit 10 needs to be in a normal operating state. When the direct current provided by the direct current power supply 200 is input to the direct current/direct current conversion circuit 10, a high inductor current flows through the inductor L in the direct current/direct current conversion circuit 100. In this case, although a status of the inductor L may be detected according to the inductor characteristic formula, the current flowing through the inductor L is extremely high. If the inductor L is an abnormal inductor, an inductor current flowing through the inductor L is greater than that flowing through a normal inductor. In this detection manner, the abnormal inductor L needs to be allowed to operate. When the abnormal inductor L operates, the inductor current flowing through the inductor L is sufficient to damage the power conversion apparatus 100. As a result, this detection manner in which the actual inductance of the inductor L is directly detected according to the inductor characteristic formula cannot avoid a safety problem caused by an abnormality of the inductor L, and this detection manner cannot be applied to a startup phase of the power conversion apparatus 100. In the startup phase of the power conversion apparatus 100, if the direct current/direct current conversion circuit 10 is not controlled to be started for operating, no current flows through the inductor L in the direct current/direct current conversion circuit 10; or if the direct current/direct current conversion circuit 10 is controlled to be started for operating, when the inductor L is abnormal, an abnormal current has been generated on the power conversion apparatus 100, and a safety risk already exists. In this case, it may be too late to calculate the inductance of the inductor L according to the typical inductor characteristic formula.

An embodiment of this application provides a second power conversion apparatus, to implement safety detection on an inductor L on a direct current side of a power conversion apparatus 100 in a startup process of the power conversion apparatus 100. The second power conversion apparatus 100 implements inductor detection in a startup phase based on detection after sending a PWM driver gating signal during startup. As shown in FIG. 4, the second power conversion apparatus 100B includes a second control circuit 20B and a direct current/direct current conversion circuit 10. The direct current/direct current conversion circuit 10 includes an inductor L and a switching transistor S. The switching transistor S is configured to connect in parallel to a direct current power supply, and the inductor L is connected in series to a loop formed by the direct current power supply and the switching transistor S. The second control circuit 20B is configured to: in a startup process of the second power conversion apparatus 100B, control the switching transistor S to be continuously turned on within target duration or control the switching transistor to be turned on and off within a target quantity of switching cycles; and perform an inductor L abnormality handling operation after the target duration or the target quantity of switching cycles when a current flowing through the inductor L is greater than a preset current threshold.

In some possible implementations, the second control circuit 20B may output a drive signal to the switching transistor S, and control, based on the drive signal, the switching transistor S to be turned on. The switching transistor S may be controlled to be turned on based on drive signals in different forms. In an example, the drive signal may be a high-level signal with a continuous effective pulse width. In this case, a voltage conversion ratio of the direct current/direct current conversion circuit 10 for voltage conversion processing on an input direct current is a fixed value. Duration of the effective pulse width of the drive signal is the target duration. In an example, the drive signal may be a level signal with a specific duty cycle. The duty cycle is a ratio of duration of the effective pulse width to duration of a low level (or a level of 0) in the drive signal within one switching cycle, and indicates a ratio of duration in which the switching transistor is controlled to be in a turn-on state to duration in which the switching transistor is controlled to be in a turn-off state, in the switching cycle. The switching transistor is controlled to be turned on based on the switching cycle, and a voltage conversion capability of the direct current/direct current conversion circuit 10 may be adjusted and the like by adjusting the duty cycle of the drive signal in the switching cycle. Regardless of whether the switching transistor S is controlled to be turned on based on the target duration or the target quantity of switching cycles, charging current duration of the inductor L is controlled by controlling actual effective turn-on duration of the switching transistor S.

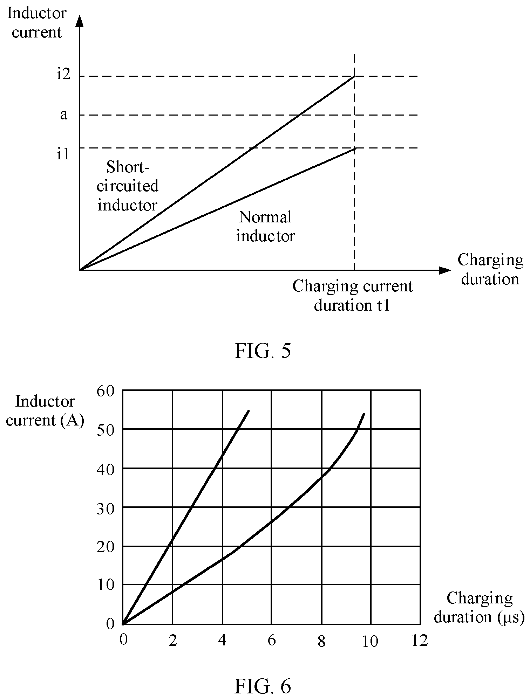

In the embodiment shown in FIG. 4 of this application, each inductor L has a rated inductance, namely, a normal inductance L1 during normal operating. When an input voltage of the direct current/direct current conversion circuit 10 is determined, for example, a voltage Upv provided by a direct current power supply 200, the normally operating inductor L has a corresponding rated peak current i1. It can be learned from an inductor characteristic formula L*di/dt=U (where i is a current, t is effective charging duration, di is a current variation, dt is a time variation, U is an input voltage, and L is an actual inductance) that, as shown in FIG. 5, for example, the switching transistor S is controlled to be turned on based on the target duration, and in this case, the target duration is the effective charging duration of the inductor L. When the inductor L normally operates, the inductance of the inductor L is the normal inductance L1, and the charging current duration of the inductor L is fixed at t1. In this case, a formula for calculating the corresponding rated peak current i1 is: i1=Upv*t1/L1. When the inductor L is short-circuited due to a short circuit of a winding coil, the inductance of the inductor L attenuates. In this case, the inductance of the inductor L is an attenuated inductance L2, and the charging current duration is fixed at t1. In this case, a formula for calculating a corresponding abnormal peak current i2 is: i2=Upv*t1/L2. In conclusion, it can be learned that when the inductor L is in a normal operating state and a short-circuit state, actual inductances of the inductor L are different. When the current duration is fixed, output currents corresponding to the two states are different. Therefore, in a startup phase of the second power conversion apparatus 100B, only the second control circuit 20B needs to control the switching transistor S to be turned on based on the target duration or the target quantity of switching cycles for operating, so that the inductor L can output a current. The target duration or the target quantity of switching cycles can meet a requirement that different currents are output in different operating states of the inductor L and that a current output by the short-circuited inductor L is not excessively high, thereby avoiding a safety problem. After responding to power-on of the second power conversion apparatus 100B, the second control circuit 20B may obtain the current flowing through the inductor L. When the current flowing through the inductor L is greater than the preset current threshold, it indicates that the inductor L has a short-circuit abnormality. In this case, the second control circuit 20B may perform a related inductor abnormality handling operation. In actual application, the input direct current is affected by an actual component and transmission, so that a value of the current is not a constant value in an ideal case. In other words, the current has a periodic alternating current fluctuation characteristic due to a non-ideal power supply voltage waveform and a characteristic of a load, that is, the current is presented as a ripple current. In an ideal case, a value of the preset current threshold is obtained through calculation based on a rated current corresponding to the inductor L. However, in actual application, due to a ripple current characteristic, there is a specific error between an actual current and an ideal current. Therefore, the value of the preset current threshold designed based on the rated current may be adjusted based on a change characteristic of a ripple current of a product in actual application.

As shown in FIG. 6, an inductor L with a rated inductance is used as an example. It can be seen that, within fixed same charging time (that is, fixed target duration or a fixed target quantity of switching cycles), a current of a short-circuited inductor L increases faster than a current of a normal inductor L. For example, a rated peak current of the inductor L during normal operating is 30 A. When the switching transistor S is controlled to be turned on based on the target duration, 4 µs may be selected as the target duration. After charging time of 4 µs, for the normal inductor L, a current (18 A) at an output end of the inductor L is less than the rated peak current of 30 A; and for the short-circuited inductor L, a current (44 A) at an output end of the inductor L is greater than the rated peak current of 30 A. The current of 44 A is sufficient to distinguish between the abnormal inductor and the normal inductor, and does not cause a problem of a component loss.

For example, there is a fixed calculation conversion formula (for example, the foregoing current calculation formula based on an inductor characteristic) between an inductance and a current. Determining whether the current flowing through the inductor L is greater than the preset current threshold in the foregoing embodiment may also be understood as calculating a current actual inductance of the inductor L based on the current at the output end of the inductor L and determining, based on whether the actual inductance is less than (it can be learned from the foregoing current calculation formula that a lower inductance indicates a higher current) the preset inductance threshold, whether the inductor L is short-circuited.

In some possible implementations, the inductor abnormality handling operation includes controlling the second power conversion apparatus 100B to be shut down, outputting inductor abnormality alarm information, reducing input power of the inductor L, or the like. In this embodiment of this application, after an abnormality of the inductor L is detected, different inductor abnormality handling operations may be adaptively set and performed based on different actual product application requirements and application scenarios.

In some possible implementations, the inductor abnormality handling operation may be triggered and performed in different forms based on different hardware designs of the second control circuit 20B.

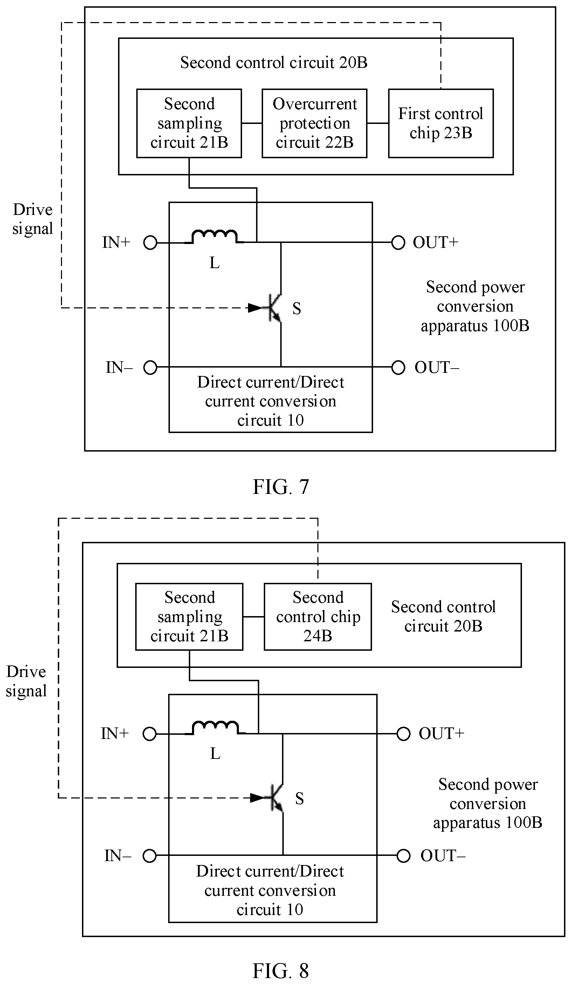

In some examples, as shown in FIG. 7, the second control circuit 20B includes a second sampling circuit 21B, an overcurrent protection circuit 22B, and a first control chip 23B. The second sampling circuit 21B is separately connected to an output end of an inductor L and the overcurrent protection circuit 22B. The overcurrent protection circuit 22B is further connected to the first control chip 23B. The second sampling circuit 21B is configured to: obtain a current flowing through the inductor L, and transmit the current to the overcurrent protection circuit 22B. The overcurrent protection circuit 22B is configured to output an abnormality indication signal to the first control chip 23B when the current flowing through the inductor L is greater than a preset current threshold, where the abnormality indication signal indicates that adjacent winding coils of the inductor L are short-circuited to each other. The first control chip 23B is configured to perform an inductor abnormality handling operation based on the abnormality indication signal. In this embodiment of this application, the overcurrent protection circuit 22B is disposed in the second control circuit 20B in the second power conversion apparatus 100B. In this case, the overcurrent protection circuit 22B determines, based on the sampled current, whether the current at the output end of the inductor L is greater than the preset current threshold, to determine an abnormality of the inductor L. When the inductor L is short-circuited, the overcurrent protection circuit 22B may send the corresponding abnormality indication signal to the first control chip 23B. The first control chip 23B performs the corresponding inductor abnormality handling operation based on the abnormality indication signal.

In some examples, as shown in FIG. 8, the second control circuit 20B includes a second sampling circuit 21B and a second control chip 24B. The second sampling circuit 21B is separately connected to an output end of an inductor L and the second control chip 24B. The second sampling circuit 21B is configured to: obtain a current flowing through the inductor L, and transmit the current to the overcurrent protection circuit 22B. The second control chip 24B is configured to perform an inductor L abnormality handling operation when the current flowing through the inductor L is greater than a preset current threshold. In this embodiment of this application, the second sampling circuit 21B may sample and obtain the current at the output end of the inductor L, and the second control chip 24B determines, based on the current at the output end of the inductor L, whether the inductor L is abnormal. When the current at the output end of the inductor L is greater than the preset current threshold, it indicates that adjacent winding coils of the inductor L are short-circuited to each other, and the second control chip 24B may perform the corresponding inductor abnormality handling operation.

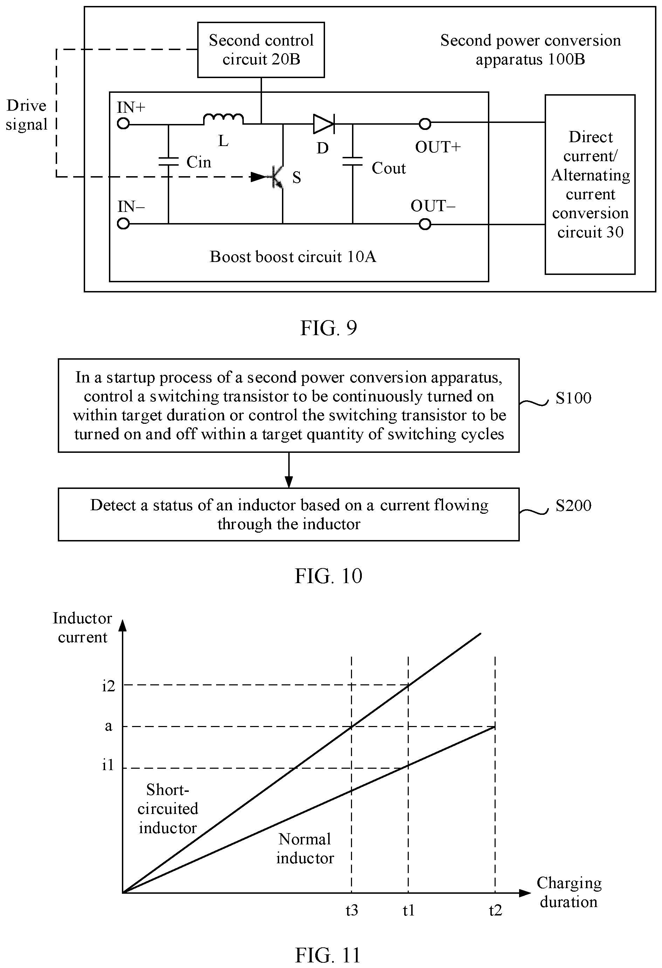

In some examples, the direct current/direct current conversion circuit 10 may be a direct current boost circuit. For example, the direct current boost circuit may be a boost boost circuit. As shown in FIG. 9, the boost boost circuit 10A includes the inductor L and the switching transistor S that are described in the foregoing embodiment. In addition, the boost boost circuit 10A further includes an input capacitor Cin, an output capacitor Cout, a diode D, and the like. The diode D is connected in series to an output end of the inductor L, and the switching transistor S is connected between the inductor L and the diode D. The input capacitor Cin and the output capacitor Cout are separately connected in parallel to the switching transistor S, the input capacitor Cin is connected to an input end side of the inductor L, and the output capacitor Cout is connected to an output end side of the diode D. For example, the input capacitor Cin is connected between a positive input end IN+ and a negative input end IN- of the direct current/direct current conversion circuit 10. The output capacitor Cout is connected between a positive output end OUT+ and a negative output end OUT- of the direct current/direct current conversion circuit 10. The diode D is connected between the output end of the inductor L and the positive output end OUT+ of the direct current/direct current conversion circuit 10. In this embodiment of this application, the input capacitor Cin and the output capacitor Cout may respectively implement filtering processing at an input end and an output end of the direct current/direct current conversion circuit 10. The diode D can ensure undirectional conductivity of the output end of the inductor L. After the input capacitor Cin is disposed, a voltage at the input capacitor Cin is an input voltage of the direct current/direct current conversion circuit 10.

In some possible implementations, the second power conversion apparatus 100B may further include a direct current/alternating current conversion circuit. An input end of the direct current/alternating current conversion circuit is connected to the output end of the direct current/direct current conversion circuit. The direct current/alternating current conversion circuit is configured to convert a direct current, provided by the direct current/direct current conversion circuit 10, at the output end of the inductor L into an alternating current. FIG. 9 shows an example circuit topology based on the boost boost circuit 10A. A positive input end and a negative input end of the direct current/alternating current conversion circuit 30 are correspondingly connected to a positive output end OUT+ and a negative output end OUT- of the boost boost circuit respectively. A positive input end IN+ and a negative input end IN- of the boost boost circuit 10A obtain a direct current from a direct current power supply 200, and the obtained direct current is filtered by the input capacitor Cin. After the second control circuit 20B controls, based on a drive signal, the switching transistor S to be turned on, the obtained direct current flows through the inductor L, and a boosted direct current is obtained after boost processing implemented through turn-on control of the switching transistor S and based on an inductor characteristic of the inductor L. The boosted direct current is unidirectionally conducted by the diode D, and flows through the positive output end OUT+ and the negative output end OUT- of the boost boost circuit; and the boosted direct current is transmitted to the direct current/alternating current conversion circuit 30 after being filtered by the output capacitor Cout. The direct current/alternating current conversion circuit 30 may perform direct current-alternating current inversion processing on the input direct current to obtain an alternating current. The alternating current may be provided to a power grid, an alternating current load, or the like.

In some possible implementations, the power supply system 1000 may further include components such as a transformer and an alternating current filter circuit.

An embodiment of this application further provides a power device. The power device includes a circuit board and a power conversion apparatus, and the power conversion apparatus is disposed on the circuit board. The power conversion apparatus of the electronic device may be the second power conversion apparatus 100B described in the foregoing embodiment. For related technical principles and beneficial effect of disposing the second power conversion apparatus 100B in the power device, refer to related descriptions of disposing the second power conversion apparatus 100B in the power supply system 1000. Details are not described herein again.

An embodiment of this application further provides a detection method. The detection method is applied to the second power conversion apparatus 100B including the structures described in the embodiments in FIG. 4, FIG. 7, FIG. 8, and FIG. 9. Specifically, the detection method may include the following operations of step S100 and step S200 shown in FIG. 10.

S100: In a startup process of the second power conversion apparatus 100B, control a switching transistor S to be continuously turned on within target duration or control the switching transistor to be turned on and off within a target quantity of switching cycles.

In some possible implementations, in the startup process of the second power conversion apparatus 100B, as shown in FIG. 4, a second control circuit 20B in the second power conversion apparatus 100B may control, based on the target duration or the target quantity of switching cycles, the switching transistor S to be turned on to control charging duration of an inductor L. A current flowing through the inductor L has a specific value within fixed charging duration. When the inductor L is not short-circuited, the charging duration makes the current at an output end of the inductor L less than or equal to a rated peak current of the inductor L; or when the inductor L is short-circuited, the charging duration makes the current at an output end of the inductor L greater than a rated peak current of the inductor L by a specific value. It can be learned from analysis of the embodiment shown in FIG. 5 that the charging duration of the inductor L is controlled by setting the target duration or the target quantity of switching cycles. A normal inductor L and a short-circuited inductor L have current signals with different currents within same charging duration. In addition, the target duration or the target quantity of switching cycles make the current at the output end of the inductor L output by the short-circuited inductor L greater than the rated peak current of the normal inductor L by only a specific value, so that the current at the output end of the inductor L in a short-circuit case is not sufficient to damage the circuit. In a subsequent processing process, abnormality detection may be implemented based on different currents.

In an example, the rated peak current is determined based on an input voltage of the inductor L, a rated inductance of the inductor L, and target duration; or the rated peak current is determined based on an input voltage of the inductor L, a rated inductance of the inductor L, and the target quantity of switching cycles. The rated inductance is an inductance of the inductor L during normal operating. For example, both the target duration and the target quantity of switching cycles are used to determine charging current duration t1 of the inductor L during charging. When the inductor L normally operates, the inductance of the inductor L is a normal inductance L1, and the charging current duration is fixed at t1. In this case, a formula for calculating the corresponding rated peak current i1 is: i1=Upv*t1/L1.

In an example, an abnormal peak current is determined based on an input voltage of the inductor L, an attenuated inductance of the inductor L, and the target duration; or the rated peak current is determined based on an input voltage of the inductor L, a rated inductance of the inductor L, and the target quantity of switching cycles. The attenuated inductance is an inductance of the inductor L in a short-circuit state. For example, when the inductor L is short-circuited, the inductance of the inductor L attenuates. In this case, the inductance of the inductor L is the attenuated inductance L2, and the charging current duration is fixed at t1. In this case, a formula for calculating the corresponding abnormal peak current i2 is: i2=Upv*t1/L2.

In an example, as shown in FIG. 5, a preset current threshold a may be set to a value between the rated peak current i1 and the abnormal peak current i2 based on the target duration.

For example, a first absolute value is equal to a second absolute value, the first absolute value is an absolute value of a difference between the preset current threshold a and the rated peak current, and the second absolute value is an absolute value of a difference between the preset current threshold and the abnormal peak current. In this embodiment of this application, because i1<a<i2, an equation between the first absolute value and the second absolute value may also be expressed as: (i2-a)=(a-i1). It can be seen from FIG. 5 that, in this embodiment of this application, the difference between the preset current threshold a and the rated peak current i1 is equal to the difference between the preset current threshold a and the abnormal peak current i2. In this case, a detection result may have high reliability.

In some possible implementations, the corresponding target duration or target quantity of switching cycles may be designed based on the preset current threshold a. For example, the preset current threshold a is designed based on the target duration, the rated inductance of the normal inductor L is L1, and the attenuated inductance of the short-circuited inductor L is L2. As shown in FIG. 11. Effective conduction duration t2 required when the current that is at the output end of the inductor L and that is output by the normal inductor L reaches the preset current threshold a may be calculated; and effective conduction duration t3 required when the current that is at the output end of the inductor L and that is output by the short-circuited inductor L reaches the preset current threshold a is calculated. Specific duration between the time t3 and the time t2 (t3<t2) is selected as fixed duration t1, namely, the charging current duration.

For example, according to the formula i1=Upv*t1/L1 and the formula i2=Upv*t1/L2, when (i2-a)=(a-i1) needs to be met, the target duration corresponding to the preset current threshold a in this case may be obtained, namely, the charging current duration t1. A formula for calculating the charging current duration t1 is as follows:$t 1 = 2 a / Upv \left(1/L1+1/L2\right) .$

In the formula, a is the selected preset current threshold a that meets a requirement of (i2-a)=(a-i1), Upv is the input voltage of the direct current/direct current conversion circuit 10, L1 is the rated inductance of the inductor L during normal operating, and L2 is the attenuated inductance after the inductor L is short-circuited.

In actual application, there may be a specific calculation error in selecting values of parameters such as i1, i2, a, t1, t2, t3, L1, and L2. However, a requirement of t3<t1<t2 usually still needs to be met within an error range.

In some possible implementations, the switching transistor S may be controlled to be turned on based on drive signals in different forms.

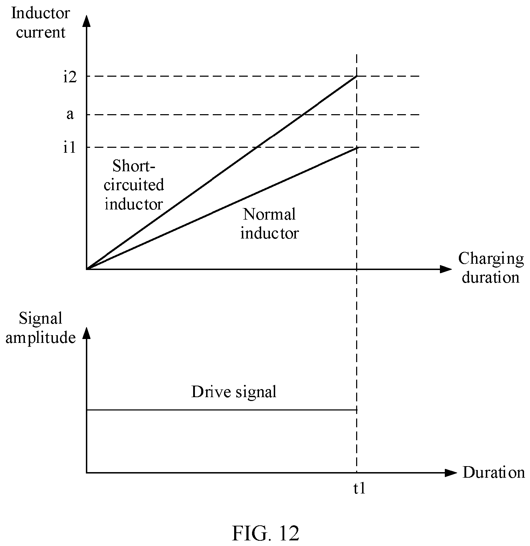

In an example, the drive signal may be a high-level signal with a continuous effective pulse width. As shown in FIG. 12, target duration of the drive signal is the charging current duration t1. Within the target duration, the current flowing through the inductor L increases at a fixed proportion per unit time.

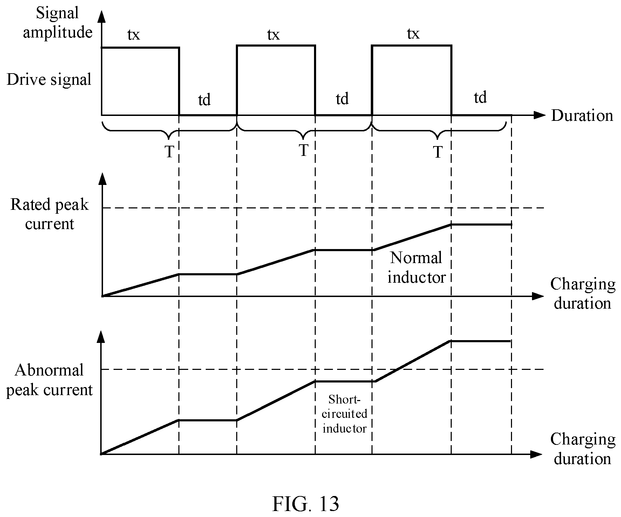

In an example, the drive signal may be a level signal with a specific duty cycle. In this case, as shown in FIG. 13, a 1^{st} coordinate system indicates a diagram in which an effective pulse width of the drive signal periodically changes with time. It can be seen that the drive signal has a specific switching cycle T. In the switching cycle T, there is specific effective pulse width duration tx and specific low-level duration td based on a preset duty cycle. In this case, total effective pulse width duration may be obtained by summing up effective pulse width duration tx in one or more cycles T, and the total effective pulse width duration is the charging current duration t1 of the inductor L. A 2^{nd} coordinate system is a diagram in which a current of the normal inductor L changes with time within the charging current duration t1. A 3^{rd} coordinate system is a diagram in which a current of the short-circuited inductor L changes with time within the charging current duration t1. It can be seen from FIG. 13 that, within unit duration including a specific quantity of switching cycles T, values of duty cycles in all switching cycles T are different (that is, ratios of the effective pulse width duration tx to the low-level duration td are different), and therefore, the current flowing through the inductor L also changes per unit time. Therefore, a value of the current flowing through the inductor L may be adjusted based on different duty cycles, to adjust a voltage conversion capability of the direct current/direct current conversion circuit 10. In addition, when the switching transistor S is controlled to be turned on based on the target duration, the current flowing through the inductor L increases to a specific current within short time. However, when the switching transistor S is controlled to be turned on based on the target quantity of switching cycles T, it takes longer time for the current flowing through the inductor L to increase to the same current in the solution of the target duration. Therefore, controlling the switching transistor S to be turned on based on the switching cycle T can more easily avoid a safety problem caused by an excessively fast rise in the current, thereby improving detection safety.

For example, the duty cycle in the switching cycle of the drive signal may be adjusted based on a pulse width modulation (pulse width modulation, PWM) technology.

S200: Detect a status of the inductor L based on the current flowing through the inductor L.

In some possible implementations, when the current flowing through the inductor L is greater than the preset current threshold a, an inductor abnormality handling operation is performed. For example, there is a fixed calculation conversion formula (for example, the foregoing current calculation formula) between an inductance and a current. Determining whether the current at the output end of the inductor L is greater than the preset current threshold in the foregoing embodiment may also be understood as calculating a current actual inductance of the inductor L based on the current flowing through the inductor L and determining, based on whether the actual inductance is less than (it can be learned from the foregoing current calculation formula that a lower inductance indicates a higher current) the preset inductance threshold, whether the inductor L is short-circuited.

In some possible implementations, as shown in FIG. 7 and FIG. 8, the current at the output end of the inductor L may be sampled and obtained through a second sampling circuit 21B in the second control circuit 20B.

In an example, the inductor abnormality handling operation includes controlling the second the power conversion apparatus 100B to be shut down, outputting inductor abnormality alarm information, reducing input power of the inductor L, or the like. In this embodiment of this application, after an abnormality of the inductor L is detected, different inductor abnormality handling operations may be adaptively set and performed based on different actual product application requirements and application scenarios.

For example, when the second control circuit 20B is of the structure shown in FIG. 8, the second control chip 24B may determine the current flowing through the inductor L, and perform the inductor abnormality handling operation when the current flowing through the inductor L is greater than the preset current threshold a.

For example, when the second control circuit 20B is of the structure shown in FIG. 7, the operation of step S200 may specifically include the following steps.

S210: Generate an abnormality indication signal when the current flowing through the inductor L is greater than the preset current threshold.

For example, as shown in FIG. 7, an overcurrent protection circuit 22B is disposed in the second control circuit 20B in the second power conversion apparatus 100B. In this case, the overcurrent protection circuit 22B determines whether the current flowing through the inductor L is greater than the preset current threshold, to determine an abnormality of the inductor L. When the inductor L is short-circuited, the overcurrent protection circuit 22B may send the corresponding abnormality indication signal to the first control chip 23B. The abnormality indication signal indicates that the inductor L is in an abnormal state.

S220: Perform the inductor abnormality handling operation based on the abnormality indication signal.

For example, as shown in FIG. 7, the first control chip 23B may perform the inductor abnormality handling operation based on the abnormality indication signal.

In some possible implementations, when the current flowing through the inductor L is less than or equal to the preset current threshold, the second power conversion apparatus 100B is kept started for operating. In this embodiment of this application, in step S200, when the current flowing through the inductor L is less than or equal to the preset current threshold, it indicates that the inductor at a direct current side of the second power conversion apparatus 100B is normal. When the second power conversion apparatus 100B is also normal, the second power conversion apparatus 100B may be controlled to be normally started for operating.

In this embodiment of this application, according to the detection method described in the embodiments in FIG. 10, FIG. 11, FIG. 12, and FIG. 13, fault detection can be performed on the inductor L in the power conversion apparatus in a startup process of the second power conversion apparatus 100B. This prevents a circuit component from being damaged due to a short circuit of the inductor L while ensuring detection accuracy.

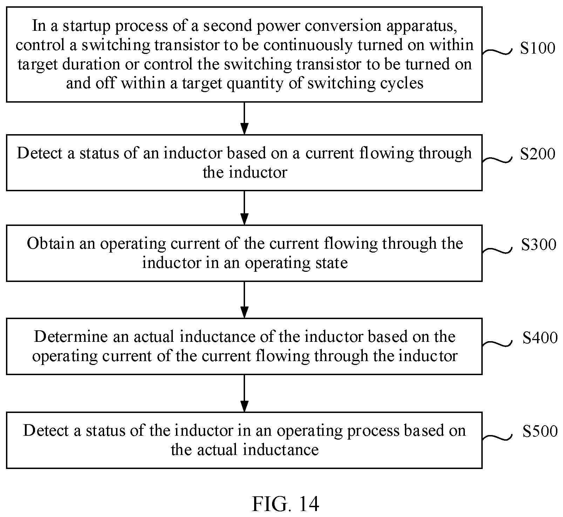

In some possible implementations, after the inductor of the power conversion apparatus is detected during startup based on the solution in step S100 and step S200, the inductor L of the power conversion apparatus may be further detected in an operating phase of the direct current/direct current conversion circuit 10 in the power conversion apparatus based on the following operations of step S300 to step S500 shown in FIG. 14.

S300: Obtain an operating current of the current flowing through the inductor L in an operating state.

In some possible implementations, as shown in FIG. 4, when the direct current/direct current conversion circuit 10 in the second power conversion apparatus 100B is in an operating state, the operating current of the current flowing through the inductor L is sampled and obtained through the second control circuit 20B shown in FIG. 4. For example, as shown in FIG. 7, FIG. 8, and FIG. 9, the current flowing through the inductor L may be specifically sampled and obtained through the second sampling circuit 21B in the second control circuit.

S400: Determine an actual inductance of the inductor L based on the operating current of the current flowing through the inductor L.

In some possible implementations, as shown in FIG. 4, the second control circuit 20B may calculate the actual inductance of the inductor L based on the operating current of the current flowing through the inductor L, and determine, based on the actual inductance, whether the inductor L is abnormal. For example, the actual inductance may be calculated through the first control chip 23B shown in FIG. 7 or the second control chip 24B shown in FIG. 8.

In an example, when the actual inductance of the inductor L is calculated, the actual inductance may be calculated according to calculation algorithms in different operating conditions and based on whether the operating current of the current flowing through the inductor L is a discontinuous inductor current or a continuous inductor current. For example, determining the actual inductance of the inductor L based on the operating current of the current flowing through the inductor L includes: when the operating current of the current flowing through the inductor L is a continuous inductor current, determining the actual inductance of the inductor L through calculation according to a continuous inductor current algorithm and based on the operating current of the current flowing through the inductor L; or when the operating current of the current flowing through the inductor L is a discontinuous inductor current, determining the actual inductance of the inductor L through calculation according to a discontinuous inductor current algorithm and based on the operating current of the current flowing through the inductor L. In this embodiment of this application, a corresponding calculation method may be matched based on different inductor current signal conditions, to implement comprehensive abnormality calculation of the inductor L in different operating conditions in the operating state.

S500: Detect a status of the inductor L in an operating process based on the actual inductance.

In some possible implementations, when the actual inductance of the inductor L is less than a preset inductance threshold, an inductor abnormality handling operation is performed. It can be learned from the principle description of the embodiment in FIG. 5 that in the operating state, when an input voltage is known, after the operating current of the current flowing through the inductor L is detected, whether the inductor current is in a continuous operating condition or a discontinuous operating condition is detected in step S400, to match a corresponding algorithm to calculate the actual inductance of the inductor L. It can be learned from the principle description of the embodiment in FIG. 5 that when the inductor L is in a short-circuit state, the inductance of the inductor L attenuates. Therefore, when the actual inductance is less than the preset inductance threshold, the inductor abnormality handling operation may be performed in the operating state of the second power conversion apparatus 100B. For related descriptions of performing the inductor abnormality handling operation in step S500, refer to the descriptions in the foregoing embodiment. Details are not described herein again.

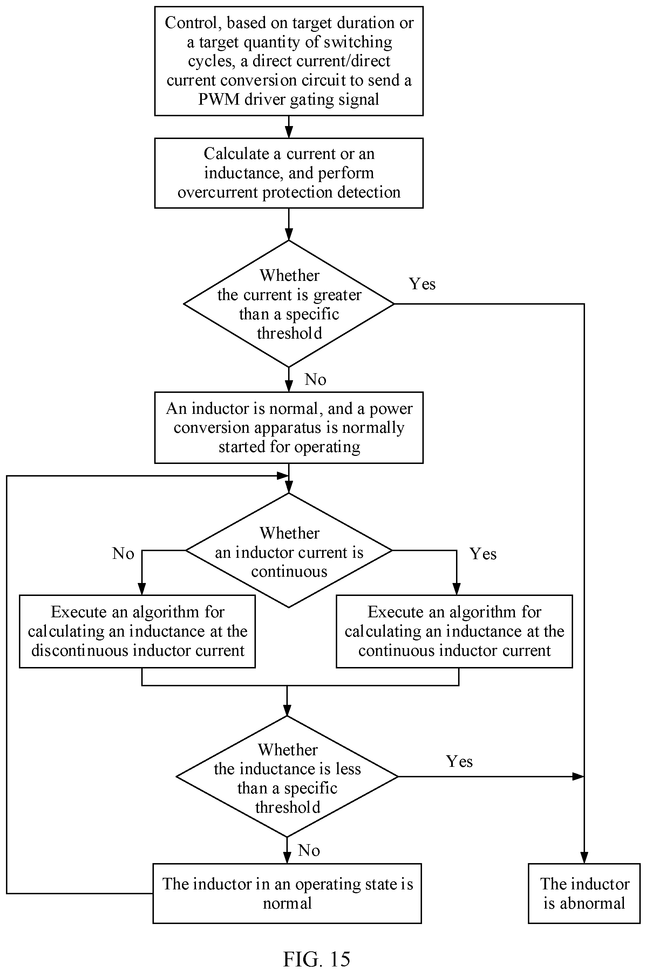

For example, the operations of step S100 to step S500 are completely performed. A processing procedure of the second control circuit 20B may be shown in FIG. 15. First, in a phase of a startup process of the second power conversion apparatus 100B, the second control circuit 20B may control, based on fixed target duration or a fixed target quantity of switching cycles, the direct current/direct current conversion circuit 10 to send a PWM driver gating signal, so that a current flows through an output end of the inductor L. In this case, the target duration or the target quantity of switching cycles meet the conditions: When a normal inductor L operators, a current flowing through the inductor L is close to a rated peak current of the inductor L; or when a short-circuited inductor L operates, a current flowing through the inductor L is greater than a rated peak current by a specific range. Based on this operation, the abnormal inductor can be distinguished when component safety is ensured. In step S200, the operating current (or the inductance) of the current flowing through the inductor L may be calculated, and a calculation result is compared with a preset threshold, to determine, in the startup process of the second power conversion apparatus 100B, whether the inductor L on a direct current side of the second power conversion apparatus 100B is an abnormal short-circuited inductor. If it is determined that the inductor L is an abnormal short-circuited inductor, the inductor abnormality handling operation may be performed. If it is determined that the inductor L is a normal inductor and the second power conversion apparatus 100B has no other fault or problem, the second power conversion apparatus 100B may be controlled to be normally started for operating. Then, when the second power conversion apparatus 100B is in a normal operating state, the operating current of the current flowing through the inductor L in an operating state of the direct current/direct current conversion circuit 10 may be sampled and obtained in step S300. In step S400, the actual inductance in the operating state is calculated. When the actual inductance is specifically calculated, whether the inductor current is continuous may be detected, and a corresponding calculation manner may be used based on a detection result. Then, in step S500, whether the inductor L is normal is determined based on whether the actual inductance is less than the specific threshold. When the actual inductance of the inductor L is greater than or equal to the specific threshold, it indicates that the inductor L is a normal inductor, and it indicates that there is no fault in this detection. When the actual inductance of the inductor L is less than the specific threshold, it indicates that the inductor L is a short-circuited inductor, and there is an abnormal inductor fault in this detection. In this case, the corresponding inductor abnormality handling operation may be performed.

In this embodiment of this application, the inductor on the direct current side of the power conversion apparatus is detected in the startup phase of the power conversion apparatus in step S100 and step S200. In addition, in a phase of step S300 to step S500, the inductor on the direct current side of the power conversion apparatus is detected when the direct current/direct current conversion circuit in the power conversion apparatus is in an operating phase. Based on the foregoing steps, the inductor on the direct current side of the power conversion apparatus can be detected in an entire operating procedure. In addition, in the phase of step S300 to step S500, when the inductor is detected during operating, the inductor is distinguished based on whether the inductor current is a discontinuous current or a continuous current, and different calculation manners are adapted through distinguishing. In this embodiment of this application, systematic inductor detection can be implemented in all operating conditions and all phases on the direct current side of the power conversion apparatus. This improves operating safety and reliability on the direct current side.

An embodiment of this application further provides a computer-readable storage medium. The computer-readable storage medium includes instructions. When the instructions are run on a control chip, a processor or the control chip is enabled to perform the detection method described in the foregoing embodiment (for example, the detection method described in FIG. 10, FIG. 11, FIG. 12, FIG. 13, FIG. 14, and FIG. 15).

For example, the control chip in embodiments of this application may be a field-programmable gate array (field-programmable gate array, FPGA), an application-specific integrated chip (application-specific integrated circuit, ASIC), a system on chip (system on chip, SoC), a central processing unit (central processing unit, CPU), a network processor (network processor, NP), a digital signal processing circuit (digital signal processor, DSP), a micro controller unit (micro controller unit, MCU), a programmable controller (programmable logic device, PLD), or another integrated chip.

It should be understood that sequence numbers of the foregoing processes do not mean execution sequences in embodiments of this application. The execution sequences of the processes should be determined based on functions and internal logic of the processes, and should not constitute any limitation on implementation processes of embodiments of this application.

A person of ordinary skill in the art may be aware that, in combination with the examples described in embodiments disclosed in this specification, modules and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that this implementation goes beyond the scope of this application.

It may be clearly understood by a person skilled in the art that, for the purpose of convenient and brief description, for a detailed working process of the foregoing system, apparatus, and module, refer to a corresponding process in the foregoing method embodiments, and details are not described herein again.

In the several embodiments provided in this application, it should be understood that the disclosed system, device, and method may be implemented in another manner. For example, the described device embodiment is merely an example. For example, division into the modules is merely logical function division and may be other division during actual implementation. For example, a plurality of modules or components may be combined or integrated in another device, or some features may be ignored or not performed. In addition, the displayed or discussed mutual couplings or direct couplings or communication connections may be implemented through some interfaces. The indirect couplings or communication connections between the devices or modules may be implemented in an electrical form, in a mechanical form, or in another form.

The modules described as separate components may or may not be physically separate, and components displayed as modules may or may not be physical modules, may be located in one device, or may be distributed on a plurality of devices. Some or all of the modules may be selected based on an actual requirement to achieve the objectives of the solutions of embodiments.

In addition, functional modules in embodiments of this application may be integrated into one device, or each of the modules may exist alone physically, or two or more modules are integrated into one device.

All or some of the foregoing embodiments may be implemented by software, hardware, firmware, or any combination thereof. When a software program is used to implement embodiments, all or some of embodiments may be implemented in a form of a computer program product. The computer program product includes one or more computer instructions. When the computer program instructions are loaded and executed on the computer, the procedure or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a DVD), a semiconductor medium (for example, a solid state disk (Solid State Disk, SSD)), or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power conversion apparatus, comprising a control circuit and a direct current/direct current conversion circuit, wherein the direct current/direct current conversion circuit comprises an inductor and a switching transistor, the switching transistor is configured to connect in parallel to a direct current power supply, the inductor is connected in series to a loop formed by the direct current power supply and the switching transistor, and the control circuit is configured to:
in a startup process of the power conversion apparatus, control the switching transistor to be continuously turned on within target duration or control the switching transistor to be turned on and off within a target quantity of switching cycles; and
perform an inductor abnormality handling operation after the target duration or the target quantity of switching cycles when a current flowing through the inductor is greater than a preset current threshold.

2. The power conversion apparatus according to claim 1, wherein the control circuit comprises a sampling circuit, an overcurrent protection circuit, and a control chip, the sampling circuit is separately connected to the inductor and the overcurrent protection circuit, and the overcurrent protection circuit is further connected to the control chip;
the sampling circuit is configured to: obtain the current flowing through the inductor, and transmit the current to the overcurrent protection circuit;
the overcurrent protection circuit is configured to output an abnormality indication signal to the control chip when the current flowing through the inductor is greater than the preset current threshold; and
the control chip is configured to perform the inductor abnormality handling operation based on the abnormality indication signal.

3. The power conversion apparatus according to claim 1, wherein the control circuit comprises a sampling circuit and a control chip, and the sampling circuit is separately connected to the inductor and the control chip;
the sampling circuit is configured to: obtain the current flowing through the inductor, and transmit the current to the overcurrent protection circuit; and
the control chip is configured to perform the inductor abnormality handling operation when the current flowing through the inductor is greater than the preset current threshold.

4. The power conversion apparatus according to any one of claims 1 to 3, wherein the preset current threshold is greater than a rated peak current; the rated peak current is determined based on an input voltage of the inductor, a rated inductance of the inductor, and the target duration, or the rated peak current is determined based on an input voltage of the inductor, a rated inductance of the inductor, and the target quantity of switching cycles; and the rated inductance is an inductance of the inductor during normal operating.

5. The power conversion apparatus according to claim 4, wherein the preset current threshold is further less than an abnormal peak current; the abnormal peak current is determined based on the input voltage of the inductor, an attenuated inductance of the inductor, and the target duration, or the abnormal peak current is determined based on the input voltage of the inductor, an attenuated inductance of the inductor, and the target quantity of switching cycles; and the attenuated inductance is an inductance of the inductor in a state in which adjacent winding coils are short-circuited to each other.

6. The power conversion apparatus according to claim 5, wherein a first absolute value is equal to a second absolute value, the first absolute value is an absolute value of a difference between the preset current threshold and the rated peak current, and the second absolute value is an absolute value of a difference between the preset current threshold and the abnormal peak current.

7. The power conversion apparatus according to any one of claims 1 to 6, wherein the control circuit is further configured to:
when the current flowing through the inductor is less than or equal to the preset current threshold, keep the power conversion apparatus started.

8. The power conversion apparatus according to any one of claims 1 to 7, wherein the direct current/direct current conversion circuit is a boost boost circuit.

9. The power conversion apparatus according to any one of claims 1 to 8, wherein the power conversion apparatus further comprises a direct current/alternating current conversion circuit, and an input end of the direct current/alternating current conversion circuit is connected to an output end of the direct current/direct current conversion circuit.

10. The power conversion apparatus according to any one of claims 1 to 9, wherein the inductor abnormality handling operation comprises:
controlling the power conversion apparatus to be shut down, outputting inductor abnormality alarm information, or reducing input power of the inductor.

11. A detection method, applied to a power conversion apparatus, wherein the power conversion apparatus comprises a direct current/direct current conversion circuit, the direct current/direct current conversion circuit comprises an inductor and a switching transistor, the switching transistor is configured to connect in parallel to a direct current power supply, the inductor is connected in series to a loop formed by the direct current power supply and the switching transistor, and the method comprises:
in a startup process of the power conversion apparatus, controlling the switching transistor to be continuously turned on within target duration or controlling the switching transistor to be turned on and off within a target quantity of switching cycles; and
performing an inductor abnormality handling operation after the target duration or the target quantity of switching cycles when a current flowing through the inductor is greater than a preset current threshold.

12. The detection method according to claim 11, wherein performing the inductor abnormality handling operation when the current value flowing through the inductor is greater than the preset current threshold comprises:
obtaining an abnormality indication signal when the current flowing through the inductor is greater than the preset current threshold; and
performing the inductor abnormality handling operation based on the abnormality indication signal.

13. The detection method according to claim 11 or 12, wherein the preset current threshold is greater than a rated peak current; the rated peak current is determined based on an input voltage of the inductor, a rated inductance of the inductor, and the target duration, or the rated peak current is determined based on an input voltage of the inductor, a rated inductance of the inductor, and the target quantity of switching cycles; and the rated inductance is an inductance of the inductor during normal operating.

14. The detection method according to claim 13, wherein the preset current threshold is further less than an abnormal peak current; the abnormal peak current is determined based on the input voltage of the inductor, an attenuated inductance of the inductor, and the target duration, or the abnormal peak current is determined based on the input voltage of the inductor, an attenuated inductance of the inductor, and the target quantity of switching cycles; and the attenuated inductance is an inductance of the inductor in a state in which adjacent winding coils are short-circuited to each other.

15. The detection method according to claim 14, wherein a first absolute value is equal to a second absolute value, the first absolute value is an absolute value of a difference between the preset current threshold and the rated peak current, and the second absolute value is an absolute value of a difference between the preset current threshold and the abnormal peak current.

16. The detection method according to any one of claims 11 to 15, wherein the method further comprises:
when the current flowing through the inductor is less than or equal to the preset current threshold, keeping the power conversion apparatus started.

17. The detection method according to any one of claims 11 to 16, wherein the inductor abnormality handling operation comprises controlling the power conversion apparatus to be shut down, outputting inductor abnormality alarm information, or reducing input power of the inductor.
